# EUROPÄISCHE PATENTANMELDUNG

(11) **EP 1 703 560 A2**
(43) Veröffentlichungstag der Anmeldung: **20.09.2006**
(21) Anmeldenummer: 06005022.6
(22) Anmeldetag: 11.03.2006
(51) Int. Cl.: H01L 27/02

(54) **ESD-Schutzschaltung mit skalierbarer Stromfestigkeit und Spannungsfestigkeit**

(30) Priorität: 18.03.2005 DE 102005013686
(71) Anmelder: ATMEL Germany GmbH, 74072 Heilbronn (DE)
(72) Erfinder: Dudek, Volker, Dr., 74336 Brackenheim (DE); Graf, Michael, Dr., 71397 Leutenbach (DE); Grombach, Peter, Dipl.-Ing., 74074 Heilbronn (DE); Klaussner, Manfred, Dipl.-Ing., 74080 Heilbronn (DE)

(57) **Zusammenfassung**

Vorgestellt wird eine ESD-Schutzschaltung (10) aus Halbleiterstrukturen als Grundelementen (16; 18), deren elektrische Leitfähigkeit sich bei einer anliegenden Spannung, die einen Schwellenwert überschreitet, durchbruchartig oder lawinenartig ändert. Die ESD-Schutzschaltung (10) zeichnet sich dadurch aus, dass die ESD-Schutzschaltung (10) eine Matrix von Grundelementen aufweist, bei der eine gewünschte Stromfestigkeit durch Vorgabe einer Zahl von Grundelementen jeder Zeile und eine gewünschte Spannungsfestigkeit durch Vorgabe einer Zahl von Zeilen einstellbar ist.

## Beschreibung

Die Erfindung betrifft eine ESD-Schutzschaltung aus Halbleiterstrukturen als Grundelementen, deren elektrische Leitfähigkeit sich bei einer anliegenden Spannung, die einen Schwellenwert überschreitet, durchbruchartig oder lawinenartig ändert.

Solche Schutzschaltungen sind per se bekannt. Bei der Handhabung und dem Einsatz Integrierter Schaltkreise (IC) ist es erforderlich, die darin enthaltenen Bauelemente und Baugruppen vor der Einwirkung von Überspannungen zu schützen. Als Überspannungen sind dabei elektrische Signale zu verstehen, wie sie beispielsweise bei einer Entladung statischer Aufladung, sei es von Menschen oder Maschinenteilen über einen IC bzw. eines IC über Menschen oder Maschinenteile, auftreten. Solche Entladungsvorgänge werden auch als electrostatic discharge (ESD) bezeichnet. Werden derartige Signale, deren Amplitude mehrere kV betragen kann und bei denen Ströme im Ampere-Bereich auftreten können, einem integrierten Schaltkreis zugeführt, können irreversible Veränderungen an dessen Bauelementen oder Baugruppen erfolgen, z.B. durch Durchbrennen von Dünnschichten (thin film burn-out), Filamentierung (filamentation) und Kurzschließen von Schichtübergängen (junction spiking), Ladungsträgerinjektion in Oxidschichten oder Zerreißen von Oxidschichten (charge injection bzw. oxide rupture), was unter Umständen zu einer Zerstörung des gesamten IC führt.

Ein einfaches Beispiel einer per se bekannten Schutzschaltung ist eine Zenerdiode, die einem zu schützenden Bauelement oder einer zu schützenden Baugruppe elektrisch parallel geschaltet ist und die eine über dem Bauelement oder der Baugruppe abfallende Spannung auf den Wert der Durchbruchspannung der Zenerdiode begrenzt. Wird die Durchbruchspannung durch einen ESD-Impuls überschritten, leitet die Zenerdiode den unter Umständen hohen Entladungsstrom an dem Bauelement oder der Baugruppe vorbei zu einem Bezugspotential ab.

Bekannte ESD-Schutzstrukturen werden in der Regel für eng beschriebene Anwendungen individuell entworfen, optimiert und hergestellt, da die ESD-Festigkeit von der zu schützenden Schaltung und den Einsatzbedingungen der zu schützenden Schaltung abhängt. Andere Spannungsbereiche, zum Beispiel eine andere Versorgungsspannung oder eine andere, aus der Schaltungsumgebung resultierende Anforderung an die Spannungsfestigkeit erfordern beim Stand der Technik individuell entworfene neue ESD-Schutzstrukturen mit dem entsprechenden Aufwand für den Entwurf und die Realisierung der Herstellung durch einen geeigneten Halbleiterprozess.

Vor diesem Hintergrund besteht die Aufgabe der Erfindung in der Angabe einer ESD-Schutzschaltung, die sich mit einem verringerten Aufwand bei ihrem Entwurf und ihrer Herstellung an vorgebbare Bedingungen für die Stromfestigkeit und Spannungsfestigkeit anpassen lässt.

Diese Aufgabe wird bei einer ESD-Schutzschaltung der eingangs genannten Art dadurch gelöst, dass die ESD-Schutzschaltung eine Matrix von Grundelementen aufweist, bei der eine gewünschte Stromfestigkeit durch Vorgabe einer Zahl von Grundelementen jeder Zeile und eine gewünschte Spannungsfestigkeit durch Vorgabe einer Zahl von Zeilen einstellbar ist.

Die Erfindung ermöglicht damit, aufbauend auf einer Grundstruktur, einen für beliebige Anwendungen skalierbaren ESD-Schutz. Da die Stromfestigkeit mit der Zahl der Grundelemente jeder Zeile wächst, lässt sie sich durch eine entsprechende Zahl gleicher Grundelemente jeder Zeile als Vielfaches der Stromfestigkeit eines Grundelements einstellen. Gleiches gilt mit Blick auf die Spannungsfestigkeit und die Zahl der Zeilen. Im einfachsten Fall ist jedes Grundelement eine einfache Diode.

Eine bevorzugte Ausgestaltung der Erfindung zeichnet sich jedoch durch eine Realisierung der Matrix als Integrierte Schaltung oder als Teil einer Integrierten Schaltung aus, weil die zu schützende Schaltung in den meisten Anwendungsfällen ebenfalls als Integrierte Schaltung vorliegt. Die ESD-Schutzschaltung kann dann im Rahmen eines einzigen Halbleiterprozesses zusammen mit der zu schützenden Schaltung in einem Halbleitersubstrat hergestellt werden, was auch die mögliche Packungsdichte von Integrierten Schaltungen in erwünschter Weise erhöht.

Bevorzugt ist auch, dass jedes Grundelement einen Anodenbereich und einen Kathodenbereich mit jeweils vorgegebenen Abmessungen aufweist, jeder Anodenbereich aus Halbleitermaterial eines ersten Leitfähigkeitstyps besteht, jeder Kathodenbereich aus Halbleitermaterial eines zweiten Leitfähigkeitstyps besteht, Anodenbereiche von Grundelementen einer Zeile übergangslos ineinander übergehen, Kathodenbereiche einer Zeile übergangslos ineinander übergehen, und das Halbleitermaterial jeder Zeile durch eine dielektrische Trennstruktur gegen Halbleitermaterial jeder benachbarten Zeile isoliert ist.

Durch diese Merkmale wird eine Halbleiterstruktur als integrierbares Grundelement bereitgestellt, mit sich eine beliebige Anzahl von Elementen einer Zeile durch Aneinanderreihung übergangslos (kontinuierlich) ineinander übergehender Bereiche herstellen lässt. Die dielektrische Trennstruktur zwischen einzelnen Zeilen führt zu einem definierten und beim Schaltungsentwurf vorhersehbaren Verhalten bezüglich der Spannungsfestigkeit.

Ferner ist bevorzugt, dass parallel zu jedem Kathodenbereich zwei Anodenbereiche desselben Grundelements auf zwei seiner Seiten angeordnet sind und dass jedes Grundelement jeder Zeile, das nicht zwischen zwei weiteren Grundelementen liegt, durch ein Randelement begrenzt wird, das die beiden Anodenbereiche des Grundelements durch einen Anodenrandbereich gleichen Leitfähigkeitstyps übergangslos miteinander verbindet.

Diese Merkmale schließen einzelne Zeilen zu beiden Seiten in definierter Weise ab und führen in Verbindung mit den vorstehend genannten Merkmalen zu einer geschlossenen Ringstruktur des Anodenbereichs, der einen streifenförmigen Kathodenbereich umgibt. Im Vergleich mit einfachen Parallelschaltungen von Dioden führt dies zu einer vergrößerten Anodenfläche, was die Durchbruchfestigkeit und die Stromfestigkeit weiter positiv beeinflusst.

Eine weitere bevorzugte Ausgestaltung weist eine erste Verdrahtungsebene mit einer ersten elektrisch leitenden Fläche, die Anodenbereiche jeder Zeile flächig kontaktiert, und einer zweiten elektrisch leitenden Fläche, die von der ersten elektrisch leitenden Fläche isoliert ist und die Kathodenbereiche jeder Zeile flächig kontaktiert, auf.

Durch die flächige Kontaktierung wird eine optimale Strom- und Spannungsverteilung im ESD-Fall erreicht, was lokale Strom- und Spannungsspitzen verhindert oder zumindest verringert. Dies ist besonders vorteilhaft, weil in ESD-Fällen Stromdichten von mehreren kA pro Quadratmillimeter auftreten können.

Eine weitere bevorzugte Ausgestaltung zeichnet sich durch eine zweite Verdrahtungsebene aus, die von der ersten Verdrahtungsebene flächig durch eine dielektrische Zwischenlage getrennt ist und die elektrisch voneinander getrennte erste Teilflächen und zweite Teilflächen aufweist, wobei die ersten Teilflächen (der zweiten Verdrahtungsebene) durch mit elektrisch leitfähigem Material gefüllte Durchbrüche in der dielektrischen Zwischenlage lokal mit der ersten elektrisch leitenden Fläche (der ersten Verdrahtungsebene) und die zweiten Teilflächen (der zweiten Verdrahtungsebene) durch mit elektrisch leitfähigem Material gefüllte Durchbrüche lokal mit der zweiten elektrisch leitfähigen Fläche (der ersten Verdrahtungsebene) verbunden sind.

Diese Merkmale erlauben einen hinsichtlich der Stromverteilung, der Energiedissipation und der Strukturierung der Verdrahtungsebenen (Metallisierungsflächen) optimalen Anschluss der Anodenbereiche und Kathodenbereiche einer Zeile an die entsprechenden Bereiche benachbarter Zeilen.

Bevorzugt ist auch, dass die ESD-Schutzschaltung eine vergrabene dielektrische Schicht aufweist, die die Matrix auf einer den Verdrahtungsebenen gegenüberliegenden Seite dielektrisch isoliert.

Auf diese Weise wird der ESD-Strompfad auf zwischen den Verdrahtungsebenen und der vergrabenen Schicht liegende Querschnitte begrenzt, was die Isolierung verschiedener Zeilen gegeneinander optimiert.

Ferner ist bevorzugt, dass die dielektrischen Trennstrukturen auf die vergrabene dielektrische Schicht stoßen.

Als erwünschte Folge wird ein Stromfluss zwischen benachbarten Zeilen, der nicht von den Verdrahtungsebenen getragen wird, ausgeschlossen, was die Vorhersehbarkeit der Spannungsfestigkeit der Matrix bei einer Festlegung der Anzahl ihrer Zeilen verbessert.

Bevorzugt ist auch, dass die Anodenbereiche und Kathodenbereiche einer Zeile durch eine dielektrische Trennstruktur, die nicht auf die vergrabene dielektrische Schicht stößt, voneinander getrennt sind.

Im ESD-Fall fließt der Entladungsstrom dann durch Querschnitte zwischen dieser dielektrischen Trennstruktur und der vergrabenen Schicht. Durch die Dimensionierung dieser Trennstruktur lässt sich das sogenannte snap back Verhalten der Anordnung beeinflussen. Dabei versteht man unter dem snap back Verhalten eine Verringerung des Widerstandes der Anordnung nach einem Durchbruch und/oder bei einem Übergang einer Leitfähigkeitsstrecke in einen niederohmigen Zustand. Bei einem ausgeprägten snap back Verhalten könnte dies zu dem unerwünschten Effekt führen, dass die Spannung über der ESD-Schutzschaltung nach einem Durchbruch unter den Wert der normalen Betriebsspannung fällt, so dass ein ESD-Ereignis die Leitfähigkeit der Schutzschaltung länger aktiviert als zur Ableitung des ESD-Impulses nötig wäre. Dies würde eine grundsätzliche Anforderung an die ESD-Schutzschaltung konterkarieren, nach der die ESD-Schutzschaltung bei der regulären Versorgungsspannung inaktiv sein sollte.

Eine weitere bevorzugte Ausgestaltung zeichnet sich dadurch aus, dass der Kathodenbereich in einer Wanne aus Halbleitermaterial des zweiten Leitfähigkeitstyps liegt, in der Wanne auf einer der Anode zugewandten Seite wenigstens ein Bereich des ersten Leitfähigkeitstyps liegt, der gemeinsam mit einem Bereich des zweiten Leitfähigkeitstyps an die zweite elektrisch leitende Fläche der ersten Verdrahtungsebene angeschlossen ist, und dass Anodenbereich und Wanne durch einen zwischen der vergrabenen dielektrischen Schicht und dem Anodenbereich und der Wanne liegenden Halbleiterbereich mit Ohm'scher Leitfähigkeit des zweiten Leitfähigkeitstyps verbunden sind.

Durch diese Merkmale wird ein besonders bevorzugtes Grundelement bereitgestellt, das im ESD-Fall mit der Anode als Kollektor, dem in der Wanne liegenden Bereich mit der ersten Leitfähigkeit als Emitter und dem ebenfalls in der Wanne liegenden Bereich des zweiten Leitfähigkeitstyps als Basis arbeitet. Wegen des über die Verdrahtungsebene erzeugten Kurzschlusses zwischen Basis und Emitter zeigt die Anordnung bei niedrigen Spannungen zunächst kein Transistorverhalten. Erst ein nach erfolgtem Durchbruch zwischen Anodenbereich und Kathodenbereich fließender Strom erzeugt in der Wanne einen lateralen Potentialgradienten zwischen Emitter und Basis, der den Transistor in den niederohmigen Zustand schaltet, so dass dieser den ESD-Strom ableitet. Der genannte Schaltvorgang stellt sich bei einer Auftragung des Kollektorstroms über der Kollektor-Emitter-Spannung als steiler Anstieg des Kollektorstroms mit nur geringfügig ausgeprägtem snap back Verhalten dar, so dass das Grundelement und damit auch die Matrix im ESD-Spannungsbereich näherungsweise kein unerwünschtes "snappen" zeigt.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Fig. 1: in erstes Ausführungsbeispiel einer ESD-Schutzschaltung mit Merkmalen der Erfindung zusammen mit einer zu schützenden Schaltung;
- Fig. 2: eine perspektivische Darstellung eines Grundelements einer ESD-Schutzschaltung für eine Realisierung in Form einer Integrierten Schaltung;
- Fig. 3: eine Kennlinie eines Grundelements aus der Fig. 2; und
- Fig. 4: eine aus Grundelementen aus der Fig. 2 aufgebaute Matrix als Integrierte ESD-Schutzschaltung .

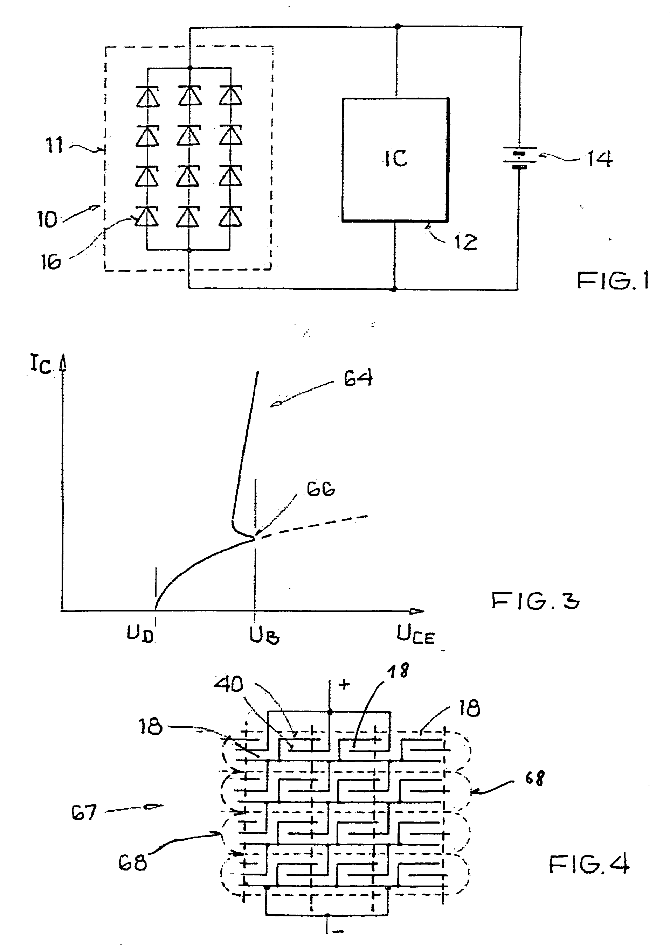

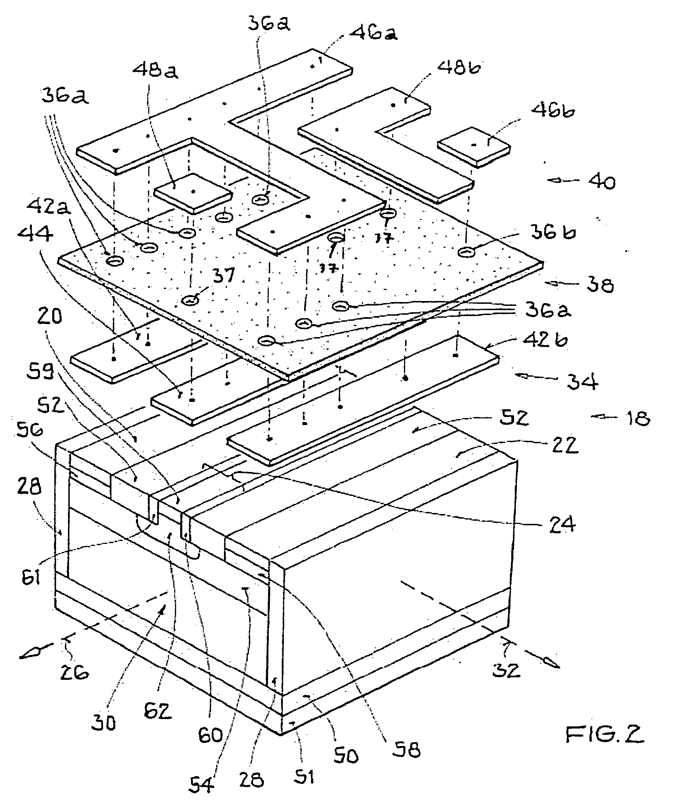

Im Einzelnen zeigt Fig. 1 eine ESD-Schutzschaltung 10, die elektrisch parallel zu einer zu schützenden Schaltung 12 an eine Versorgungsspannungsquelle 14 angeschlossen ist. Die ESD-Schutzschaltung 10 weist in der Ausgestaltung der Fig. 1 Zenerdioden als Grundelemente 16 auf, die in Form einer Matrix 11 aus n = 4 Zeilen und m = 3 Spalten angeordnet sind. Die Zenerdioden einer Spalte sind in Reihe geschaltet, so dass die Spannungsfestigkeit der ESD-Schutzschaltung dem n-fachen der Durchbruchspannung eines einzelnen Grundelements 16 entspricht. Durch Festlegung der Anzahl in Reihe geschalteter Grundelemente 16 lässt sich die Durchbruchspannung der gesamten ESD-Schutzschaltung 10 damit an verschiedene Anforderungen anpassen, ohne dass die einzelnen Grundelemente 16 geändert werden müssen. Die Durchbruchspannung der ESD-Schutzschaltung 10 ist dabei so festzulegen, dass sie größer als die normale Versorgungsspannung ist, so dass die Versorgungsspannung im regulären Betrieb an der zu schützenden Schaltung 12 anliegt.

Beim Auftreten eines ESD-Impulses, dessen Spannungshöhe über der Durchbruchspannung der ESD-Schutzschaltung 10 liegt, wird bei symmetrischer Spannungsverteilung über der Matrix 11 die Durchbruchspannung jedes Grundelements 16 überschritten, so dass diese den Entladestrom ableiten können. Dabei verteilt sich der Entladestrom im Idealfall gleichmäßig auf die zueinander elektrisch parallel liegenden Spalten der Matrix 11, so dass die StromLeitfähigkeit und damit die Stromfestigkeit der ESD-Schutzschaltung durch die Zahl ihrer Spalten, also durch die Zahl von Grundelementen 16 in jeder Zeile, festlegbar ist.

Es versteht sich daher, dass die Werte der Zeilenzahl n und der Spaltenzahl m von den Anforderungen an die Spannungsfestigkeit und an die Stromfestigkeit abhängig zu wählen ist, wodurch ein skalierbarer ESD-Schutz für verschiedene Anforderungen auf der Basis eines einzigen Typs eines Grundelements bereitgestellt wird und bei dem eine gewünschte Stromfestigkeit durch Vorgabe einer Zahl von Grundelementen jeder Zeile und eine gewünschte Spannungsfestigkeit durch Vorgabe einer Zahl von Zeilen einstellbar ist.

Zenerdioden stellen dabei lediglich eine Ausgestaltung eines Grundelements 16 dar, das im Allgemeinen als Halbleiterstruktur realisiert ist, deren elektrische Leitfähigkeit sich bei einer anliegenden Spannung, die einen Schwellenwert überschreitet, durchbruchartig oder lawinenartig ändert. Wie weiter unten noch näher ausgeführt wird, können daher auch Transistoreigenschaften aufweisende Grundelemente verwendet werden. Prinzipiell kann die Matrix aus separaten Grundelementen 16 aufgebaut werden. Bevorzugt ist jedoch eine Realisierung der Matrix als Integrierte Schaltung oder als Teil einer Integrierten Schaltung.

Eine Ausgestaltung eines Grundelements 18 für eine Integrierte ESD-Schutzschaltung 10 ist in der Fig. 2 dargestellt. Bei dieser Ausgestaltung besitzt das Grundelement 18 wenigstens einen Anodenbereich 20, 22 und einen Kathodenbereich 24 mit jeweils vorgegebenen Abmessungen. Jeder Anodenbereich 20, 22 besteht aus Halbleitermaterial eines ersten Leitfähigkeitstyps und der Kathodenbereich 24 weist Halbleitermaterial eines zweiten Leitfähigkeitstyps auf.

Eine Zeile der Matrix entsteht durch Aneinanderreihung mehrerer Grundelemente 18 in der durch die gestrichelte Linie 26 vorgegebenen Richtung. Dabei erfolgt die Aneinanderreihung im Stadium des Entwurfs der ESD-Schutzschaltung 10. Bei der Herstellung werden die Grundelemente durch übliche Strukturierungsschritte eines Halbleiterprozesses in einem durchgehenden Substrat, das aus Halbleitermaterial 30 aufweist, so erzeugt, dass Anodenbereiche 20, 22 von Grundelementen einer Zeile in der Richtung 26 übergangslos ineinander übergehen und Kathodenbereiche 24 einer Zeile in der Richtung 26 übergangslos ineinander übergehen. Dielektrische Trennstrukturen 28 begrenzen das Halbleitermaterial 30 in der Richtung 32 gegen Halbleitermaterial benachbarter Zeilen.

Die elektrische Kontaktierung des Anodenbereichs 20, 22 und des Kathodenbereichs 24 erfolgt in der Darstellung der Fig. 2 von oben durch einen Verbund aus einer ersten Verdrahtungsebene oder Metallisierung 34, einer mit Durchbrüchen 36a, 36b, 37 versehenen dielektrischen Zwischenlage 38 und einer zweiten Verdrahtungsebene oder Metallisierung 40. Die Verdrahtungsebenen 34, 40 bestehen zum Beispiel aus Aluminium. Die Durchbrüche 36a, 36b, 37 sind mit elektrisch leitfähigem Material, zum Beispiel ebenfalls mit Aluminium, gefüllt.

Die erste Verdrahtungsebene 34 weist eine erste elektrisch leitende Fläche 42a, 42b auf, die Anodenbereiche 20, 22 sämtlicher Grundelemente 18 jeder Zeile flächig kontaktiert. Eine zweite elektrisch leitende Fläche 44 der ersten Verdrahtungsebene 34, die von der ersten elektrisch leitenden Fläche 42a, 42b getrennt verläuft und damit elektrisch gegen die Fläche 42a, 42b isoliert ist, kontaktiert die Kathodenbereiche 24 sämtlicher Grundelemente 18 jeder Zeile in flächiger Weise.

Die zweite Verdrahtungsebene 40 ist von der ersten Verdrahtungsebene 34 flächig durch die dielektrische Zwischenlage 38 getrennt und weist erste Teilflächen 46a, 46b und zweite Teilflächen 48a, 48b auf. Die ersten Teilflächen 46a, 46b der zweiten Verdrahtungsebene 40 sind durch die mit elektrisch leitfähigem Material gefüllten Durchbrüche 36a, 36b in der dielektrischen Zwischenlage 38 lokal mit der ersten elektrisch leitenden Fläche 42a, 42b der ersten Verdrahtungsebene 34 verbunden und schließen damit die Anodenbereiche 20, 22 an. Entsprechend sind die zweiten Teilflächen 48a, 48b der zweiten Verdrahtungsebene 40 durch die mit elektrisch leitfähigem Material gefüllten Durchbrüche 37 lokal mit der zweiten elektrisch leitfähigen Fläche 44 der ersten Verdrahtungsebene 34 verbunden und schließen damit den Kathodenbereich 24 an.

Wie man leicht erkennt, kann ein solches Grundelement 18 als Elementarzelle dienen, aus der eine Zeile durch Aneinanderreihung beliebig vieler weiterer Grundelemente 18 längs der Richtung 26 aufgebaut werden kann, wobei sich die elektrische Kontaktierung ebenfalls längs der Richtung 26 fortsetzt. In der Richtung 32 ragt die Teilfläche 48b etwas über den rechten Rand der Teilflächen 46a, 46b hinaus, so dass sie die rechte dielektrische Trennstruktur 28 in dieser Richtung 32 überbrückt. Als Folge wird eine Teilfläche 46a eines in der Richtung 33 benachbart zu dem dargestellten Grundelement 18 anzuordnenden gleichen Grundelements 18 einer benachbarten Zeile elektrisch an die Teilfläche 48b des dargestellten Grundelements 18 angeschlossen, sodass sich eine Reihenschaltung von der Art ergibt, die durch die Spalten der Matrix aus Grundelementen 16 in der Fig. 1 dargestellt ist.

Im Rahmen einer bevorzugten Ausgestaltung weist das Grundelement 18 ferner eine vergrabene dielektrische Schicht 50 auf, die sich über die gesamte Matrix erstreckt und daher die Matrix auf einer den Verdrahtungsebenen 34, 40 gegenüberliegenden Seite dielektrisch isoliert. Dieses Merkmal ergibt sich zum Beispiel bei einem SOI-Substrat (SOI = semiconductor on insulator) als Ausgangsmaterial zur Herstellung der Matrix. In der Fig. 2 ergibt sich die SOI-Struktur durch die Anordnung des Halbleitermaterials 30 auf der vergrabenen dielektrischen Schicht 50, die auf einer Substratschicht 51 liegt.

Die bereits erwähnten dielektrischen Trennstrukturen 28 erstrecken sich bevorzugt soweit in die Tiefe des Halbleitermaterials 30, dass sie auf die vergrabene dielektrische Schicht 50 stoßen. Auf diese Weise wird eine vollkommene dielektrische Trennung des Halbleitermaterials verschiedener Zeilen der Matrix in der Tiefe des Halbleitermaterials 30 erzeugt, so dass die elektrische Kontaktierung und Verbindung verschiedener Grundelemente 18 nur in definierter, durch die Geometrie der Verdrahtungsebenen 34, 40 vorgegebener Weise, erfolgt.

Prinzipiell können die Anodenbereiche 20, 22 und der Kathodenbereich 24 im Halbleitermaterial 30 direkt aneinander angrenzen und mit dem sich dann ausbildenden pn-Übergang eine Diode bilden. Bevorzugt werden die genannten Bereiche jedoch an der Oberfläche des Halbleitermaterials des Grundelements 18, die an die erste Verdrahtungsebene 34 angrenzt, durch wenigstens eine dielektrische Trennstruktur 52, die nicht auf die vergrabene dielektrische Schicht 50 stößt, voneinander getrennt. Eine solche Trennstruktur 52 beeinflusst das snap back-Verhalten und erlaubt damit eine Einstellung dieses Verhaltens. Sie kann zum Beispiel als zumindest teilweise mit einem Isoliermittel gefüllte Vertiefung, d.h. eine shallow trench insulation (STI) ausgeführt werden. Als Isoliermittel kann beispielsweise ein PECVD-Oxid verwendet werden.

Unter der Trennstruktur 52 befindet sich in einer einfachen Ausgestaltung Halbleitermaterial 30 mit relativ hohem ohmschen Widerstand. Bevorzugt ist jedoch, dass die das Grundelement 18 zur Anpassung seiner ESD-Eigenschaften unterhalb der Isolierstruktur 52 im Halbleitermaterial 30 eine weitere Schicht 54 des zweiten Leitfähigkeitstyps aufweist, die eine höhere Dotierung als das Halbleitermaterial 30 besitzt.

Für ein besseres Verständnis wird im Folgenden von einer p-Leitfähigkeit als erstem Leitfähigkeitstyp und einer n-Leitfähigkeit als zweitem Leitfähigkeitstyp ausgegangen. Unter den p-dotierten Anodenbereichen 20, 22 befindet sich eine n-dotierte extension-Schicht 56, 58, die jeweils höher dotiert ist als die n-Schicht 54. Der bereichsweise n-dotiertes Halbleitermaterial 59 aufweisende Kathodenbereich 24 wird in der Richtung 32 beidseitig durch p-dotierte Bereiche 60 und 61 begrenzt, die in einer n-dotierten Wanne 62 in der schwächer n-dotierten Schicht 54 liegen. Die p-dotierten Bereiche 60 und 61 werden mit dem n-dotierten Halleitermaterial 59 des Kathodenbereichs 24 durch die Teilfläche 44 der ersten Verdrahtungsebene 34 kurzgeschlossen. Das n-dotierte Halbleitermaterial 59 liegt damit zusammen mit den p-dotierten Bereichen 60 und 61 in der Wanne 62 aus n-dotiertem Halbleitermaterial, wobei die Anodenbereiche 20, 22 und die Wanne 62 durch einen zwischen der vergrabenen dielektrischen Schicht 50 und dem Anodenbereich 20, 22 und der Wanne 62 liegenden Halbleiterbereich 54 mit Ohm'scher Leitfähigkeit des zweiten Leitfähigkeitstyps (n) verbunden sind.

Das soweit beschriebene Grundelement 18 stellt prinzipiell einen lateralen, bipolaren pnp-Transistor mit über die zweite elektrisch leitfähige Fläche 44 der ersten Verdrahtungsebene 34 kurzgeschlossenen Basisbereichen 59 und Emitterbereichen 60, 61 sowie Kollektor 20, 22 dar. Die n-Wanne 62 stellt die Basis-Dotierung des lateralen pnp-Tansistors dar. Wenn das Potential der Anodenbereiche 20, 22 wegen eines ESD-Impulses negativer wird als das Potential des Kathodenbereichs 24, wird der pn-Übergang zwischen den Anodenbereichen 20, 22 und den darunter liegenden Schichten 56, 58 zunächst gesperrt, bis es bei weiter anwachsender ESD-Spannung als Folge innerer Feldkräfte in Verbindung mit einer lawinenartigen Trägervermehrung zum Durchbruch zwischen den als Kollektor arbeitenden Anodenbereichen 20, 22 und den darunter liegenden Schichten 56, 58 kommt. Der Durchbruch führt zu einem Stromfluss durch die Halbleiterschicht 54 und die als Basis arbeitenden Bereiche 59, 62 (Avalanche-Effekt).

Wegen des gemeinsamen Anschlusses von Basis (Bereiche 59, 62) und Emitter (Bereiche 60, 61) des lateralen pnp-Tansistors zeigt das Grundelement 18 zunächst kein Transistorverhalten.

Mit zunehmendem Stromfluss zwischen Basis (Bereiche 59, 62) und Kollektor (Anodenbereiche 20, 22) kommt es zu einem Spannungsabfall längs eines Widerstands-Pfades in der n-Wanne 62 unterhalb der Emitterbereiche 60, 61. Wenn der Wert dieses Spannungsabfalls eine Einsatzspannung U_{B} überschreitet, wird der Basis-Emitter-Übergang in Durchlassrichtung gepolt. Dies führt zu einer Injektion von Minoritätsladungsträgem aus den Emitterbereichen 60, 61 in die als Basis-Dotierung dienende n-Wanne 62 und damit zu einem "Schalten" des Grundelements 18 in einen niederohmigen Zustand, das mit einer Spannungsverminderung (snap-back; vgl. Fig. 3) und einem erhöhten Stromfluss aufgrund des zusätzlichen Diffusionsstroms zwischen Emitter 60, 61 und Kollektor 20, 22 verbunden ist, wodurch die Stromtragfähigkeit der Struktur etwa um einen Faktor fünf steigt.

Die unterhalb der Anodenbereiche 20, 22 vorgesehenen vergleichsweise hoch n dotierten Schichten 56, 58 stellen eine Durchbruch-Dotierung (breakdown doping) dar und dienen zur Anpassung der Clamp-Spannung, also der Begrenzungsspannung für externe Beschaltungsmaßnahmen. Außerdem könnte die Halbleiterstruktur des Grundelements 18 ohne diese Dotierung aufgrund von lokalen Felderhöhungen an den Rändern der hochdotierten p⁺-Anodenbereiche 20, 22 brechen, was den tragbaren Strom begrenzen würde und/oder zu Beschädigungen des Grundelements 18 führen könnte.

Fig. 3 zeigt eine Kennlinie 64 eines einzelnen Grundelements 18, bei der der Kollektorstrom I_{c} über der Kollektor-Emitterspannung U_{CE} aufgetragen ist. Der Kollektorstrom I_{c} steigt nach dem Erreichen der Durchbruchspannung U_{D} stark an, um dann zunächst abzuflachen. Dies entspricht dem geschilderten Lawinendurchbruch. Bei weiter steigender Spannung steigt der Strom entsprechend flach weiter, bis der beschriebene Transistor am snap back Punkt 66 in den niederohmigen Zustand schaltet. Der Snapback-Punkt, also das Strom-Spannungs-Wertepaar, bei dem der Basis-Emitter-Übergang durchlässig wird, lässt sich über eine Variation der Breite der Emitterbereiche 60, 61, aber auch über eine Veränderung der Breite der STI-Isolierung 52 einstellen, wobei die STI-Isolierung auch wegfallen kann.

Wie für den Fachmann offensichtlich ist, dient eine dem Grundelement 18 entsprechende Halbleiterstruktur, die jedoch jeweils komplementär dotiert ist (n statt p und umgekehrt) zum Schutz vor einer Entladung mit umgekehrtem Ladungsvorzeichen.

Fig. 4 zeigt eine Matrix 67 aus n = 4 Zeilen mit je m = 3 Grundelementen 18 mit der zweiten Verdrahtungsebene 40 und mit zusätzlichen Randelementen 68, die jede Zeile abschließen. Die Randelemente 68 weisen insbesondere nicht im Detail dargestellte halbkreisförmige Anodenbereiche zur übergangslosen Verbindung der Anodenbereiche 20, 22 eines Grundelements 18 am Anfang und am Ende jeder Zeile auf. Die halbkreisförmigen Anodenbereiche liegen ebenfalls innerhalb einer durch die vergrabene dielektrische Schicht 50 und die vertikalen Trennstrukturen 28 aus der Fig. 2 gebildeten Bauelementbox, so dass die Halbleiterbereiche der einzelnen Zeilen vollkommen gegen Halbleiterbereiche benachbarter Zeilen isoliert sind und nur über die zweite Verdrahtungsebene 40 in definierter Weise miteinander verschaltet sind.

Mit dieser auf der SOI-Technologie basierenden dielektrischen Isolierung der Zeilen lassen sich einzelne Zeilen zu der beschriebenen Matrix 67 mit wählbaren Werten der Zeilenzahl n und der Spaltenzahl m so zusammenfügen, dass die Spannungsfestigkeit der Zeilen mit der Zahl der Zeilen skaliert. Die Kennlinie einer solchen Matrix lässt sich auf die in der Fig. 3 dargestellte Kennlinie eines einzelnen Grundelements 18 abbilden, wobei sich die Skalierung der Spannungsachse mit der Zahl der Zeilen und die Skalierung der Stromachse mit der Zahl der Grundelemente pro Zeile ändert. Es ist insbesondere so, dass der snap back Spannungswert in guter Näherung proportional zur Zahl der Zeilen ist.

## Patentansprüche

1. ESD-Schutzschaltung (10) aus Halbleiterstrukturen als Grundelementen (16; 18), deren elektrische Leitfähigkeit sich bei einer anliegenden Spannung, die einen Schwellenwert überschreitet, durchbruchartig oder lawinenartig ändert, **dadurch gekennzeichnet, dass** die ESD-Schutzschaltung (10) eine Matrix von Grundelementen aufweist, bei der eine gewünschte Stromfestigkeit durch Vorgabe einer Zahl von Grundelementen jeder Zeile und eine gewünschte Spannungsfestigkeit durch Vorgabe einer Zahl von Zeilen einstellbar ist.

2. ESD-Schutzschaltung (10) nach Anspruch 1, **gekennzeichnet durch** eine Realisierung der Matrix (11, 67) als Integrierte Schaltung oder als Teil einer Integrierten Schaltung.

3. ESD-Schutzschaltung (10) nach Anspruch 1 oder 2, **dadurch gekennzeichnet, dass** jedes Grundelement (18) wenigstens einen Anodenbereich (20, 22) und einen Kathodenbereich (24) mit jeweils vorgegebenen Abmessungen aufweist, jeder Anodenbereich (20, 22) aus Halbleitermaterial eines ersten Leitfähigkeitstyps besteht, jeder Kathodenbereich (24) Halbleitermaterial (59) eines zweiten Leitfähigkeitstyps aufweist, Anodenbereiche (20, 22) von Grundelementen (18) einer Zeile übergangslos ineinander übergehen, Kathodenbereiche (24) einer Zeile übergangslos ineinander übergehen, und das Halbleitermaterial jeder Zeile durch eine dielektrische Trennstruktur (28) gegen Halbleitermaterial jeder benachbarten Zeile isoliert ist.

4. ESD-Schutzschaltung (10) nach Anspruch 3, **dadurch gekennzeichnet, dass** parallel zu jedem Kathodenbereich (24) zwei Anodenbereiche (20, 22) desselben Grundelements (18) auf zwei seiner Seiten angeordnet sind und dass jedes Grundelement (18) jeder Zeile, das nicht zwischen zwei weiteren Grundelementen (18) liegt, einseitig durch ein Randelement (68) begrenzt wird, das die beiden Anodenbereiche (20, 22) des Grundelements (18) durch einen Anodenrandbereich (68) gleichen Leitfähigkeitstyps übergangslos miteinander verbindet.

5. ESD-Schutzschaltung (10) nach Anspruch 3, **gekennzeichnet durch** eine erste Verdrahtungsebene (34) mit einer ersten elektrisch leitenden Fläche (42a, 42b), die Anodenbereiche (20, 22) jeder Zeile flächig kontaktiert, und einer zweiten elektrisch leitenden Fläche (44), die von der ersten elektrisch leitenden Fläche (42a, 42b) isoliert ist und die Kathodenbereiche (24) jeder Zeile flächig kontaktiert.

6. ESD-Schutzschaltung (10) nach Anspruch 5, **gekennzeichnet durch** eine zweite Verdrahtungsebene (40), die von der ersten Verdrahtungsebene (34) flächig **durch** eine dielektrische Zwischenlage (38) getrennt ist und die elektrisch voneinander getrennte erste Teilflächen (46a, 46b) und zweite Teilflächen (48a, 48b) aufweist, wobei die ersten Teilflächen (46a, 46b) **durch** mit elektrisch leitfähigem Material gefüllte Durchbrüche (36a, 36b) in der dielektrischen Zwischenlage (38) lokal mit der ersten elektrisch leitenden Fläche (42a, 42b) und die zweiten Teilflächen (48a, 48b) **durch** mit elektrisch leitfähigem Material gefüllte Durchbrüche (37) lokal mit der zweiten elektrisch leitfähigen Fläche (44) verbunden sind.

7. ESD-Schutzschaltung (10) nach Anspruch 6, **gekennzeichnet durch** eine vergrabene dielektrische Schicht (50), die die Matrix (67) auf einer den Verdrahtungsebenen (34, 40) gegenüberliegenden Seite dielektrisch isoliert..

8. ESD-Schutzschaltung (10) nach Anspruch 7, **dadurch gekennzeichnet, dass** die dielektrischen Trennstrukturen (28) aus Anspruch 3 auf die vergrabene dielektrische Schicht (50) stoßen.

9. ESD-Schutzschaltung (10) nach Anspruch 7 oder 8, **dadurch gekennzeichnet, dass** die Anodenbereiche (20, 22) und Kathodenbereiche (24) einer Zeile durch eine dielektrische Trennstruktur (52), die nicht auf die vergrabene dielektrische Schicht (50) stößt, voneinander getrennt sind.

10. ESD-Schutzschaltung (10) nach Anspruch 9, **dadurch gekennzeichnet, dass** der Kathodenbereich (24) in einer Wanne (62) aus Halbleitermaterial des zweiten Leitfähigkeitstyps liegt, in der Wanne (62) auf einer der Anode (20, 22) zugewandten Seite wenigstens ein Bereich (60, 61) des ersten Leitfähigkeitstyps liegt, der gemeinsam mit Halbleitermaterial 59 des zweiten Leitfähigkeitstyps an die zweite elektrisch leitende Fläche (44) der ersten Verdrahtungsebene (34) angeschlossen ist, und dass Anodenbereich (20, 22) und Wanne (62) durch einen zwischen der vergrabenen dielektrischen Schicht (50) und dem Anodenbereich (20, 22) und der Wanne (62) liegenden Halbleiterbereich (30, 54) mit Ohm'scher Leitfähigkeit des zweiten Leitfähigkeitstyps verbunden sind.
